# EUROPÄISCHE PATENTSCHRIFT

(11) **EP 2 720 372 B1**
(45) Veröffentlichungstag und Bekanntmachung des Hinweises auf die Patenterteilung: **26.11.2014**
(21) Anmeldenummer: 12188210.4
(22) Anmeldetag: 11.10.2012
(51) Int. Cl.: H03F 1/02, H03F 3/21

(54) **Analogausgabeeinheit**
Analogue output unit
Unité de sortie analogique

(43) Veröffentlichungstag der Anmeldung: 16.04.2014
(73) Patentinhaber: Siemens Aktiengesellschaft, 80333 München (DE)
(72) Erfinder: Cyron, Michael, 76187 Karlsruhe (DE); Jakobi, Waldemar, 67346 Speyer (DE); Klamm, Arnold, 76870 Kandel (DE); Kort, Valentin, 76829 Landau (DE); Marenski, Dirk, 76131 Karlsruhe (DE)

(56) Entgegenhaltungen:
- US-A1- 2002 171 481
- US-A1- 2003 090 325
- US-A1- 2007 182 490
- US-B1- 6 894 559

## Beschreibung

Die Erfindung betrifft eine Analogausgabeeinheit mit einem Gleichspannungswandler, der in Abhängigkeit einer Eingangsspannung einer Spannungsquelle und eines analogen Spannungssignals eine Versorgungsspannung einer Leistungsendstufe einstellt, die einer am Ausgang der Leistungsendstufe angeschlossenen Last eine das analoge Spannungssignal repräsentierende Ausgangsspannung einprägt.

Eine derartige Analogausgabeeinheit, z. B. eine Analogausgabeeinheit in Form einer Analogausgabebaugruppe eines Automatisierungsgerätes ist an sich bekannt. Ein Gleichspannungswandler in Form eines Abwärts- oder Aufwärtswandlers erzeugt aus einer Eingangsspannung einer Gleichspannungsquelle eine Versorgungsspannung für eine Leistungsendstufe dieser Analogausgabeeinheit. Mittels einem der Gleichspannungsquelle zugeführten analogen Spannungssignal wird die Höhe der Versorgungsspannung der Leistungsendstufe variabel gesteuert, wobei die Versorgungsspannung sich im Wesentlichen an das analoge Spannungssignal anpasst und dadurch diese Versorgungsspannung nahezu gleich dem analogen Spannungssignal ist. Falls das analoge Spannungssignal, welches z. B. zum Ansteuern eines Aktors mittels eines Ausgangsstromes bzw. einer Ausgangsspannung der Leistungsendstufe vorgesehen ist, klein ist, ist die Versorgungsspannung der Leistungsendstufe ebenfalls klein. Dagegen ist die Versorgungsspannung der Leistungsendstufe groß, falls das analoge Spannungssignal groß ist.
Diese variable Anpassung der Versorgungsspannung der Leistungsendstufe an das analoge Spannungssignal bedeutet eine Verringerung der Verlustleistung der Leistungsendstufe; denn eine einmalig eingestellte hohe Versorgungsspannung der Leistungsendstufe, die für den Betrieb eines an den Ausgang der Leistungsendstufe angeschlossenen hochohmigen Lastwiderstandes erforderlich ist, würde beim Betreiben eines niederohmigen Lastwiderstandes eine hohe Verlustleistung bewirken.

Im Hinblick auf diese variable Anpassung ist es allerdings nachteilig, dass die Versorgungsspannung nicht immer einem steilen Anstieg des analogen Spannungssignals folgen kann; denn die Anstiegsgeschwindigkeit der Versorgungsspannung, die erforderlich ist, um diesem steilen Anstieg folgen zu können, ist gewöhnlich mittels des Gleichspannungswandlers nicht zu verwirklichen. Für den Fall, dass die Versorgungsspannung dem analogen Spannungssignal nicht folgen kann, wird die Ausgangsspannung verfälscht (die Spannungsspitze wird "gekappt"), wodurch es beispielsweise bezüglich einer Aktoransteuerung zu Störungen kommen kann.

Der Erfindung liegt daher die Aufgabe zugrunde, eine Analogausgabeeinheit der eingangs genannten Art zu schaffen, die derartige Verfälschungen vermeidet.

Diese Aufgabe wird dadurch gelöst, dass die Analogausgabeeinheit eine Auswerteschaltung aufweist, welche die Abweichung der Versorgungsspannung von dem analogen Spannungssignal erfasst und zur Versorgung der Leistungsendstufe in Abhängigkeit dieser Abweichung entweder die Versorgungsspannung oder die Eingangsspannung des Gleichspannungswandlers oder eine dieser Eingangsspannung entsprechenden Bypass-Spannung der Leistungsendstufe zuführt.

Vorteilhaft ist, dass auch dann, wenn die veränderliche Versorgungsspannung dem steilen Anstieg des analogen Spannungssignals nicht "folgen kann", das Ausgangssignal nicht verfälscht wird, wobei eine kurzeitige Verlustleistungsspitze (Verlustleistungsimpuls) in Kauf genommen wird. Diese entsteht vom Zeitpunkt des steilen Anstiegs des analogen Spannungssignals bis zum Zeitpunkt, zu welchem die Versorgungsspannung der Leistungsendstufe "nachgeführt" ist bzw. zu dem die Höhe der Versorgungsspannung über der des analogen Spannungssignals liegt.

In einer Ausgestaltung der Erfindung wird die Auswerteschaltung mit einfachen schaltungstechnischen Mitteln verwirklicht, wobei die Auswerteschaltung einen steuerbaren Schalter und einen Komparator aufweist, der in Abhängigkeit der Abweichung den steuerbaren Schalter derart ansteuert, dass entweder die vom Gleichspannungswandler erzeugte, variable Versorgungsspannung oder die Eingangsspannung des Gleichspannungswandlers oder eine der Eingangsspannung entsprechenden Bypass-Spannung der Leistungsendstufe zugeführt wird.

Gemäß einer weiteren Ausgestaltung der Erfindung ist vorgesehen, einen der Eingänge des Komparators mit der Versorgungsspannung und den anderen Eingang mit dem analogen Spannungssignal und einer überlagerten Ansteuerreservespannung zu beaufschlagen. Diese Ansteuerreservespannung repräsentiert die Höhe der vorgegebenen bzw. eingestellten Abweichung. Nähert sich das analoge Spannungssignal der Versorgungsspannung bis auf diese Ansteuerreservespannung an, was auf einen steilen Anstieg des analogen Spannungssignals hinweist, wird die Leistungsendstufe mit der Eingangsspannung des Gleichspannungswandlers oder mit der Bypass-Spannung beaufschlagt.

Anhand der Zeichnung, in der ein Ausführungsbeispiel der Erfindung veranschaulicht ist, werden im Folgenden die Erfindung, deren Ausgestaltungen sowie Vorteile näher erläutert.

Es zeigen:
- Figuren 1 und 3: Bestandteile einer Analogausgabeeinheit und
- Figur 2: Verlauf eines Ausgangssignals und einer Versorgungsspannung einer Leistungsendstufe.

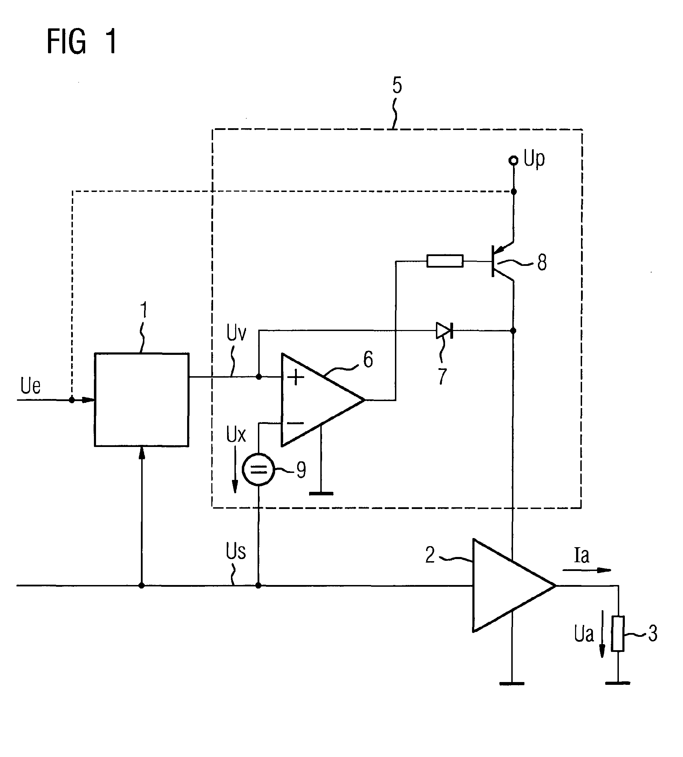

Die in den Figuren 1 bis 3 dargestellten gleichen Teile sind mit gleichen Bezugszeichen versehen.

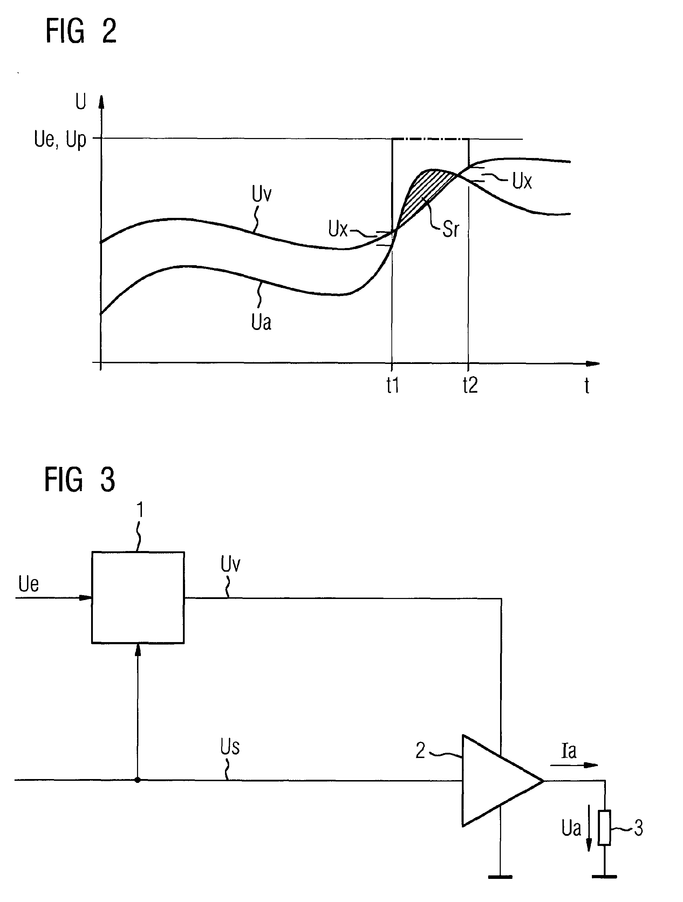

Es wird zunächst auf Figur 3 verwiesen, in der Bestandteile einer an sich bekannten Analogausgabeeinheit dargestellt sind. Eine derartige Analogausgabeeinheit ist z. B. für einen Einsatz in einem Automatisierungsgerät und zum Ansteuern eines Aktors vorgesehen. Die Analogausgabeeinheit weist einen Gleichspannungswandler 1 auf, welcher aus einer Eingangsspannung Ue einer hier nicht dargestellten Gleichspannungsquelle eine Versorgungsspannung Uv für eine Leistungsendstufe 2 bzw. für einen Ausgangsverstärker erzeugt. Ein analoges Spannungssignal Us, aufgrund dessen die Leistungsendstufe 2 einer am Ausgang dieser Leistungsendstufe 2 angeschlossenen Last 3 einen Ausgangsstrom Ia bzw. eine Ausgangsspannung Ua einprägt, steuert die Höhe der Versorgungsspannung Uv, so dass diese sich variabel an die des analogen Spannungssignals Us anpasst und diesem "folgt".

Um zu verhindern, dass aufgrund eines plötzlich auftretenden steilen Anstiegs des analogen Spannungssignals Us die Versorgungsspannung Uv diesem analogen Spannungssignal Us nicht folgen kann, wodurch am Ausgang der Leistungsendstufe die Ausgangsspannung Ua "gekappt" und der Ausgangsstrom Ia verfälscht wird, ist die Analogausgabeeinheit mit einer Auswerteschaltung 5 (Figur 1) versehen, die eine derartige Verfälschung verhindert.
Dazu erfasst die Auswerteschaltung 5 mittels eines Komparators 6 die Abweichung der Versorgungsspannung Uv von dem analogen Spannungssignal Us, wobei zur Versorgung der Leistungsendstufe 2 diese in Abhängigkeit der erfassten Abweichung die Leistungsendstufe 2 entweder mit der Versorgungsspannung Uv über eine Diode 7 oder mit einer der Eingangsspannung Ue entsprechenden Bypass-Spannung Up über einen steuerbaren Schalter 8 beaufschlagt wird. Selbstverständlich kann die Leistungsendstufe 2 anstatt mit der Bypass-Spannung Up auch mit der am Gleichspannungswandler 1 anliegenden Eingangsspannung Ue beaufschlagt werden, was in der Zeichnung durch eine gepunktete Linie 9 angedeutet ist.

Im Folgenden wird angenommen, dass der Gleichspannungswandler 1 mit einer Eingangsspannung Ue von 30 V beaufschlagt wird und dass das analoge Spannungssignal Us sowie die vom Gleichspannungswandler 1 in Abhängigkeit des analogen Spannungssignals Us erzeugte Versorgungsspannung Uv in einem Spannungsbereich zwischen 5 V bis 28 V liegt. Ferner wird angenommen, dass bei einer Abweichung der Versorgungsspannung Uv vom analogen Spannungssignal Us um <= 2 V die Leistungsendstufe 2 mit der Bypass-Spannung Up zu beaufschlagen ist. In diesem Fall wird an einer Spannungsquelle 9 eine Ansteuerreservespannung Ux von 2 V eingestellt, wobei der Komparator 6 den Schalter 8 einer öffnet, falls der Abstand der Versorgungsspannung Uv von dem analogen Spannungssignal Us größer als 2 V ist. In diesem Fall wird die Leistungsendstufe 2 mit der Versorgungsspannung Uv beaufschlagt.
Es kann vorkommen, dass am nichtinvertierenden Eingang des Komparators 6 zu einem Zeitpunkt die Versorgungsspannung Uv z. B. 8 V beträgt und am invertierenden Eingang des Komparators 6 die Spannung 8 V überschritten wird, weil die Summe aus der Ansteuerreservespannung Ux von 2 V und eines plötzlichen Anstiegs des analogen Spannungssignals Us diese Spannung von 8 V überschreitet. In diesem Fall schließt der Komparators 6 den Schalter 8. Dadurch wird die Leistungsendstufe 2 mit der Bypass-Spannung Up von 30 V beaufschlagt und es wird sichergestellt, dass das Ausgangssignal Ua nicht verfälscht wird

In diesem Zusammenhang wird im Folgenden auf Figur 2 verwiesen, in welcher der Verlauf der Versorgungsspannung Uv und des Ausgangssignals Ua dargestellt ist.

Bis zu einem Zeitpunkt t1 wird die Leistungsendstufe 2 mit der Versorgungsspannung Uv versorgt, diese Versorgungsspannung Uv folgt dem analogen Spannungssignals Us und somit dem Ausgangssignal Ua. Aufgrund eines steilen Anstiegs des Ausgangssignals Ua zum Zeitpunkt t1 wird am invertierenden Eingang des Komparators 6 der Wert der Versorgungsspannung Uv überschritten, was bedeutet, dass die Summe aus Ansteuerreservespannung Ux und analogem Spannungssignals Us die Versorgungsspannung Uv übersteigt. Dadurch wird der Schalter 8 geschlossen und die Leistungsendstufe 2 mit der Eingangspannung Ue oder der Bypass-Spannung Up beaufschlagt.

Zu einem Zeitpunkt t2 unterschreitet die Summe aus Ansteuerreservespannung Ux und analogem Spannungssignal Us die Versorgungsspannung Uv, wodurch die Leistungsendstufe 2 wieder mit der Versorgungsspannung Uv beaufschlagt wird.
Würde zwischen den Zeitpunkten t1 und t2 die Leistungsendstufe 2 mit der Versorgungsspannung Uv beaufschlagt werden, würde das Ausgangssignal Ua verfälscht werden; denn das Ausgangssignal Ua würde in diesem Zeitintervall "gekappt" werden, was in der Zeichnung durch eine Schraffierung Sr gekennzeichnet ist.

Die Erfindung lässt sich hiermit wie folgt kurz zusammenfassen:
Eine Analogausgabeeinheit mit einem Gleichspannungswandler 1, der in Abhängigkeit einer Eingangsspannung Ue einer Spannungsquelle und eines analogen Spannungssignals Us eine Versorgungsspannung Uv einer Leistungsendstufe 2 einstellt, die einer am Ausgang dieser Leistungsendstufe 2 angeschlossenen Last 3 eine das analoge Spannungssignal Us repräsentierende Ausgangsspannung Ua einprägt, zeichnet sich dadurch aus, dass die Analogausgabeeinheit eine Auswerteschaltung 5 aufweist, welche die Abweichung der Versorgungsspannung Uv von dem analogen Spannungssignal Us erfasst und zur Versorgung der Leistungsendstufe 2 in Abhängigkeit dieser Abweichung entweder die Versorgungsspannung Uv oder die Eingangsspannung Ue oder eine der Eingangsspannung Ue entsprechenden Bypass-Spannung Up der Leistungsendstufe 2 zuführt. Mittels derartiger Maßnahmen wird auch dann, wenn die veränderliche Versorgungsspannung Uv dem steilen Anstieg des analogen Spannungssignals Us nicht "folgen kann", das Ausgangssignal bzw. die Ausgangsspannung Ua nicht verfälscht.

## Patentansprüche

1. Analogausgabeeinheit mit einem Gleichspannungswandler (1), der in Abhängigkeit einer Eingangsspannung (Ue) einer Spannungsquelle und eines analogen Spannungssignals (Us) eine Versorgungsspannung (Uv) einer Leistungsendstufe (2) einstellt, die einer am Ausgang dieser Leistungsendstufe (2) angeschlossenen Last (3) eine das analoge Spannungssignal (Us) repräsentierende Ausgangsspannung (Ua) einprägt, **dadurch gekennzeichnet, dass** die Analogausgabeeinheit eine Auswerteschaltung (5) aufweist, welche die Abweichung der Versorgungsspannung (Uv) von dem analogen Spannungssignal (Us) erfasst und zur Versorgung der Leistungsendstufe (2) in Abhängigkeit dieser Abweichung entweder die Versorgungsspannung (Uv) oder die Eingangsspannung (Ue) oder eine der Eingangsspannung (Ue) entsprechenden Bypass-Spannung (Up) der Leistungsendstufe (2) zuführt.

2. Analogausgabeeinheit nach Anspruch 1, **dadurch gekennzeichnet, dass** die Auswerteschaltung (5) einen steuerbaren Schalter (8) und einen Komparator (6) aufweist, der in Abhängigkeit der Abweichung den steuerbaren Schalter (8) zum Zuführen eine der Spannungen (Uv, Ue, Up) ansteuert.

3. Analogausgabeeinheit nach Anspruch 2, **dadurch gekennzeichnet, dass** einer der Eingänge des Komparators (6) mit der Versorgungsspannung (Uv) und der andere Eingang mit dem analogen Spannungssignal (Us) und einer überlagerten Ansteuerreservespannung (Ux) beaufschlagt ist.

## Claims

1. Analogue output unit having a DC-DC converter (1) which, on the basis of an input voltage (Ue) of a voltage source and an analogue voltage signal (Us), sets a supply voltage (Uv) of a power output stage (2) which impresses an output voltage (Ua) representing the analogue voltage signal (Us) on a load (3) connected to the output of this power output stage (2), **characterized in that** the analogue output unit has an evaluation circuit (5) which detects the deviation of the supply voltage (Uv) from the analogue voltage signal (Us) and supplies either the supply voltage (Uv) or the input voltage (Ue) or a bypass voltage (Up) corresponding to the input voltage (Ue) to the power output stage (2) on the basis of this deviation in order to supply the power output stage (2).

2. Analogue output unit according to Claim 1, **characterized in that** the evaluation circuit (5) has a controllable switch (8) and a comparator (6) which controls the controllable switch (8) on the basis of the deviation in order to supply one of the voltages (Uv, Ue, Up).

3. Analogue output unit according to Claim 2, **characterized in that** the supply voltage (Uv) is applied to one of the inputs of the comparator (6) and the analogue voltage signal (Us) and a superimposed control reserve voltage (Ux) are applied to the other input.

## Revendications

1. Unité de sortie analogique, comprenant un convertisseur ( 1 ) de tension continue, qui, en fonction d'une tension ( Ue ) d'entrée d'une source de tension et d'un signal ( Us ) de tension analogique, règle une tension ( Uv ) d'alimentation d'un étage ( 2 ) final de puissance, qui imprime une tension ( Ua ) de sortie représentant le signal ( Us ) de tension analogique à une charge ( 3 ) reliée à la sortie de cet étage ( 2 ) final de puissance, **caractérisée en ce que** l'unité de sortie analogique a un circuit ( 5 ) d'exploitation, qui détecte l'écart de la tension ( Uv ) d'alimentation au signal ( Us ) de tension analogique et qui, pour l'alimentation de l'étage ( 2 ) final de puissance, envoie à l'étage ( 2 ) final de puissance soit la tension ( Uv ) d'alimentation, soit la tension ( Ue ) d'entrée, soit une tension ( Up ) de dérivation correspondant à la tension ( Ue ) d'entrée.

2. Unité de sortie analogique suivant la revendication 1, **caractérisée en ce que** le circuit ( 5 ) d'exploitation a un commutateur ( 8 ) pouvant être commandé et un comparateur ( 6 ), qui, pour l'envoi de l'une des tensions ( Uv, Ue, Up ), commande, en fonction de l'écart, le commutateur ( 8 ) pouvant être commandé.

3. Unité de sortie analogique suivant la revendication 2, **caractérisée en ce que**, à l'une des entrées du comparateur ( 6 ), est appliquée la tension ( Uv ) d'alimentation et, à l'autre entrée, le signal ( Us ) de tension analogique et une tension ( Ux ) de réserve de commande superposée.
